# EUROPEAN PATENT APPLICATION

(11) **EP 4 701 073 A1**
(43) Date of publication of application: **25.02.2026**
(21) Application number: 23938517.2
(22) Date of filing: 25.05.2023
(51) Int. Cl.: H03F 1/02, H03F 3/68

(54) **AMPLIFICATION DEVICE**

(71) Applicant: MITSUBISHI ELECTRIC CORPORATION, Chiyoda-ku Tokyo 100-8310 (JP)
(72) Inventor: KOMATSUZAKI, Yuji, Tokyo 100-8310 (JP); SAKATA, Shuichi, Tokyo 100-8310 (JP); TAGUCHI, Marie, Tokyo 100-8310 (JP); SAIKI, Kento, Tokyo 100-8310 (JP); YAMASHITA, Ao, Tokyo 100-8310 (JP)
(74) Representative: Pfenning, Meinig & Partner mbB
(86) International application number: PCT/JP2023/019418
(87) International publication number: WO 2024/241554

(57) **Abstract**

An amplifying apparatus includes: a signal splitter (3) that splits an amplification-target signal into a first input signal and a second input signal on the basis of the amplitude of the amplification-target signal; a first amplifier (4a) that amplifies the first input signal; a second amplifier (4b) that amplifies the second input signal; a synthesizing circuit (4c) that synthesizes a signal obtained after the amplification by the first amplifier (4a) and a signal obtained after the amplification by the second amplifier (4b); and a discrete variable power supply (5) that switches a power supply voltage applied to the output side of each of the first amplifier (4a) and the second amplifier (4b) on the basis of an amplitude range in which the amplitude of the amplification-target signal is included.

## Description

### TECHNICAL FIELD

The present disclosure relates to an amplifying apparatus.

### BACKGROUND ART

There are amplifying apparatuses including a carrier amplifier, a peak amplifier, and a synthesizing circuit.

As such an amplifying apparatus, for example, Patent Literature 1 discloses an amplifying apparatus including a variable power supply that applies a power supply voltage to the output side of each of a carrier amplifier and a peak amplifier.

In the amplifying apparatus, when the output impedance of a synthesizing circuit that synthesizes a signal obtained after amplification by the carrier amplifier and a signal obtained after amplification by the peak amplifier changes along with a change of the amplitude of an amplification-target signal input to each of the carrier amplifier and the peak amplifier, the power supply voltage output from the variable power supply is fixed. The change of the output impedance of the synthesizing circuit is load modulation, and the load modulation enhances the efficiency of the amplifying apparatus.

On the other hand, when the output impedance of the synthesizing circuit does not change along with a change of the amplitude of the amplification-target signal, the power supply voltage output from the variable power supply is modulated to follow the amplitude of the amplification-target signal. The modulation of the power supply voltage enhances the efficiency of the amplifying apparatus.

### CITATION LIST

### PATENT LITERATURE

Patent Literature 1: WO 2022-038695

### SUMMARY OF INVENTION

### TECHNICAL PROBLEM

In the case where the power supply voltage output from the variable power supply is modulated to follow the amplitude of the amplification-target signal, the efficiency of the variable power supply lowers as compared to the case where the power supply voltage is fixed.

The efficiency of the amplifying apparatus disclosed in Patent Literature 1 is enhanced due to the modulation of the power supply voltage at the time when the output impedance of the synthesizing circuit does not change as compared to the case where the power supply voltage is fixed when the output impedance of the synthesizing circuit does not change, but the efficiency of the amplifying apparatus lowers by an amount corresponding to the lowering of the efficiency of the variable power supply. As a result, there has been a problem that, when the output impedance of the synthesizing circuit does not change, the efficiency of the amplifying apparatus lowers undesirably as compared to when the output impedance of the synthesizing circuit changes, in some cases.

The present disclosure has been made to solve the problem described above, and an object thereof is to obtain an amplifying apparatus that can expand the amplitude range of an amplification-target signal over which the output impedance of a synthesizing circuit changes, as compared to the amplifying apparatus disclosed in Patent Literature 1.

### SOLUTION TO PROBLEM

An amplifying apparatus according to the present disclosure includes: a signal splitter to split an amplification-target signal into a first input signal and a second input signal on a basis of amplitude of the amplification-target signal; a first amplifier to perform amplification of the first input signal; a second amplifier to perform amplification of the second input signal; a synthesizing circuit to synthesize a signal obtained by the amplification performed by the first amplifier and a signal obtained by the amplification performed by the second amplifier; and a discrete variable power supply to switch a power supply voltage applied to an output side of each of the first amplifier and the second amplifier on a basis of an amplitude range in which the amplitude of the amplification-target signal is included.

### ADVANTAGEOUS EFFECTS OF INVENTION

The present disclosure can expand the amplitude range of an amplification-target signal over which the output impedance of a synthesizing circuit changes as compared to the amplifying apparatus disclosed in Patent Literature 1.

### BRIEF DESCRIPTION OF DRAWINGS

FIG. 1 is a configuration diagram depicting an amplifying apparatus according to a first embodiment.
FIG. 2 is an explanatory diagram depicting a power supply voltage output from a discrete variable power supply 5.
FIG. 3 is an explanatory diagram depicting the amplitude ratio between a first input signal and a second input signal, and the phase difference between the first input signal and the second input signal.
FIG. 4 is an explanatory diagram depicting the relationship between the backoff amount of a two-input amplifier 4 and the efficiency of the two-input amplifier 4.
FIG. 5 is an explanatory diagram depicting each of backoff of the two-input amplifier 4 and saturation of the two-input amplifier 4 in each operation mode.
FIG. 6 is a configuration diagram depicting an amplifying apparatus according to a third embodiment.
FIG. 7 is an explanatory diagram depicting the amplitude ratio between a first input signal and a second input signal, and the phase difference between the first input signal and the second input signal.
FIG. 8 is an explanatory diagram depicting the amplitude ratio between the first input signal and the second input signal, and the phase difference between the first input signal and the second input signal.

### DESCRIPTION OF EMBODIMENTS

Hereinbelow, embodiments of the present disclosure are explained in accordance with the attached figures in order to explain the present disclosure in more detail.

### First Embodiment.

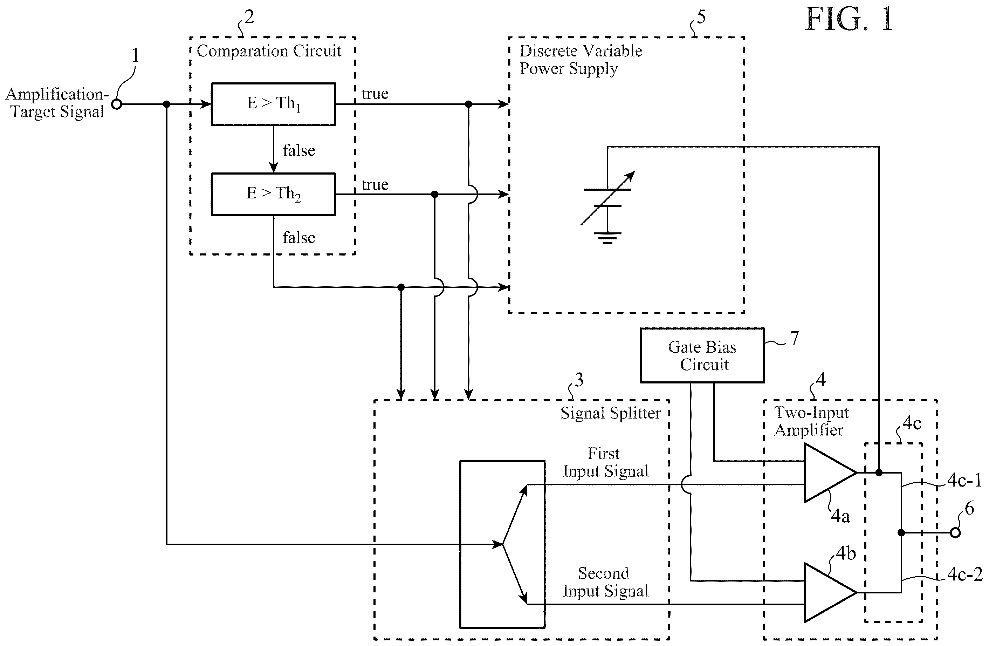

FIG. 1 is a configuration diagram depicting an amplifying apparatus according to a first embodiment.

The amplifying apparatus depicted in FIG. 1 includes an input terminal 1, a comparator 2, a signal splitter 3, a two-input amplifier 4, a discrete variable power supply 5, an output terminal 6, and a gate bias circuit 7.

The amplifying apparatus depicted in FIG. 1 includes the gate bias circuit 7. However, this is merely an example, and the gate bias circuit 7 may be provided outside the amplifying apparatus depicted in FIG. 1.

An amplification-target signal is input to the input terminal 1. The amplification-target signal input to the input terminal 1 is input to each of the comparator 2 and the signal splitter 3.

As for the amplifying apparatus depicted in FIG. 1, for convenience of explanation, the amplitude E of the amplification-target signal is explained as being equal to or greater than 0 and equal to or smaller than 1. 0 ≤ E ≤ 1.

An internal memory of the comparator 2 has stored thereon one or more mutually different thresholds.

Specifically, in the case where the number of amplitude ranges in which the amplitude E of the amplification-target signal may be included is N (N is an integer which is equal to or greater than two), mutually different (N-1) thresholds are stored on the internal memory of the comparator 2.

As for the amplifying apparatus depicted in FIG. 1, because the number of amplitude ranges in which the amplitude E of the amplification-target signal may be included is three, two thresholds Th₁ and Th₂ are stored on the internal memory of the comparator 2. The thresholds Th₁ and Th₂ represent the lower limit values of the respective amplitude ranges.

In a case where the amplification-target signal is a digital signal, for example, the comparator 2 is implemented by a Field Programmable Gate Array (FPGA) or an Application Specific Integrated Circuit (ASIC).

In a case where the amplification-target signal is an analog signal, for example, the comparator 2 is implemented by a detector and a comparator.

The comparator 2 compares each of the thresholds Th₁ and Th₂ with the amplitude E of the amplification-target signal.

The comparator 2 outputs, to each of the signal splitter 3 and the discrete variable power supply 5, a result of the comparison of each of the thresholds Th₁ and Th₂ with the amplitude E.

As for the amplifying apparatus depicted in FIG. 1, the two thresholds Th₁ and Th₂ are stored on the internal memory of the comparator 2.

The amplification-target signal is input from the input terminal 1 to the signal splitter 3.

In a case where the amplification-target signal is a digital signal, for example, the signal splitter 3 is implemented by a quadrature modulator. For example, the quadrature modulator is implemented by an FPGA or an ASIC, and an RF Digital-to-Analog Converter (RFDAC) or a DAC.

In a case where the amplification-target signal is an analog signal, for example, the signal splitter 3 is implemented by an attenuator or a variable gain amplifier, and a phase shifter.

The signal splitter 3 splits the amplification-target signal into a first input signal and a second input signal on the basis of the amplitude E of the amplification-target signal.

Specifically, on the basis of the amplitude E of the amplification-target signal and the comparison results output from the comparator 2, the signal splitter 3 splits the amplification-target signal into the first input signal and the second input signal.

The signal splitter 3 outputs the first input signal to a first amplifier 4a in the two-input amplifier 4.

The signal splitter 3 outputs the second input signal to a second amplifier 4b in the two-input amplifier 4.

The two-input amplifier 4 includes the first amplifier 4a, the second amplifier 4b, and a synthesizing circuit 4c.

As for the amplifying apparatus depicted in FIG. 1, the two-input amplifier 4 operates as a Doherty amplifier.

The first amplifier 4a may be a carrier amplifier, and the second amplifier 4b may be a peak amplifier. The first amplifier 4a may be a peak amplifier, and the second amplifier 4b may be a carrier amplifier.

For example, the first amplifier 4a is implemented by a Field Effect Transistor (FET), a Heterojunction Bipolar Transistor (HBT), or a High Electron Mobility Transistor (HEMT).

A gate terminal of the first amplifier 4a is biased for class B by the gate bias circuit 7. It is assumed that, when the first amplifier 4a performs class B operation, an output load at which the output power of the first amplifier 4a is saturated is 50 Ω, for example.

The first amplifier 4a amplifies the first input signal output from the signal splitter 3, and outputs a signal obtained after the amplification to the synthesizing circuit 4c.

For example, the second amplifier 4b is implemented by an FET, an HBT, or an HEMT.

A gate terminal of the second amplifier 4b is biased for class B by the gate bias circuit 7. It is assumed that, when the second amplifier 4b performs class B operation, an output load at which the output power of the second amplifier 4b is saturated is 50 Ω, for example.

The second amplifier 4b amplifies the second input signal output from the signal splitter 3, and outputs a signal obtained after the amplification to the synthesizing circuit 4c.

For example, the synthesizing circuit 4c is implemented by a circuit using a lumped-parameter element, a circuit using a distributed-element line, a circuit obtained by combining a lumped parameter and a distributed element, an L-C (coil-condenser) matching circuit, or a transfer line.

The synthesizing circuit 4c includes a first line 4c-1 and a second line 4c-2.

A first end of the first line 4c-1 is connected to the output side of the first amplifier 4a.

A second end of the first line 4c-1 is connected to a second end of the second line 4c-2.

For example, the first line 4c-1 is a line with an electrical length of 90 degrees at the center frequency of the amplification-target signal.

A first end of the second line 4c-2 is connected to the output side of the second amplifier 4b.

The second end of the second line 4c-2 is connected to the second end of the first line 4c-1.

For example, the second line 4c-2 is a line with an electrical length of 180 degrees at the center frequency of the amplification-target signal.

The synthesizing circuit 4c synthesizes the signal obtained after the amplification by the first amplifier 4a and the signal obtained after the amplification by the second amplifier 4b.

The synthesizing circuit 4c outputs, to the output terminal 6, a composite signal of the signal after the amplification and the signal after the amplification.

As for the amplifying apparatus depicted in FIG. 1, the first line 4c-1 is a line with the electrical length of 90 degrees, and the second line 4c-2 is a line with the electrical length of 180 degrees. However, this is merely an example, and the first line 4c-1 may be a line with the electrical length of 90 degrees, and the second line 4c-2 may be a line having an electrical length which is equivalent to the electrical length of 0 degrees. In addition, in a case where a certain phase is α, the first line 4c-1 may be a line with an electrical length of (90+α) degrees, and the second line 4c-2 may be a line with an electrical length of (90-α) degrees.

For example, the discrete variable power supply 5 is implemented by a DC (direct current)-DC converter, a back converter, an envelope amplifier, or a digital amplifier.

On the basis of an amplitude range in which the amplitude of the amplification-target signal is included, the discrete variable power supply 5 switches a power supply voltage applied to the output side of each of the first amplifier 4a and the second amplifier 4b. For example, the output sides of the first amplifier 4a and the second amplifier 4b are drain terminals of the first amplifier 4a and the second amplifier 4b, respectively.

Specifically, on the basis of the comparison results output from the comparator 2, the discrete variable power supply 5 switches the power supply voltage applied to the output side of each of the first amplifier 4a and the second amplifier 4b.

The output terminal 6 is connected to each of the second end of the first line 4c-1 and the second end of the second line 4c-2.

The output terminal 6 is a terminal for outputting, to the outside, the composite signal output from the synthesizing circuit 4c.

The gate bias circuit 7 biases the first amplifier 4a for class B. Biasing the first amplifier 4a for class B means applying a voltage close to a threshold voltage of the first amplifier 4a to the gate terminal of the first amplifier 4a.

In addition, the gate bias circuit 7 biases the second amplifier 4b for class B. Biasing the second amplifier 4b for class B means applying a voltage close to a threshold voltage of the second amplifier 4b to the gate terminal of the second amplifier 4b.

Next, operation performed by the amplifying apparatus depicted in FIG. 1 is explained.

The internal memory of the comparator 2 has stored thereon the two thresholds Th₁ and Th₂.

The threshold Th₁ is a value equivalent to the amplitude E of the amplification-target signal at which, when the power supply voltage applied to the output side of each of the first amplifier 4a and the second amplifier 4b by the discrete variable power supply 5 is X(V), the output power P_{OUT} of the two-input amplifier 4 becomes backoff point power P_{BOFF,X}. That is, the threshold Th₁ represents the lower limit value of an amplitude range of the amplification-target signal over which load modulation occurs in the two-input amplifier 4 when the power supply voltage is X(V). For example, the backoff point power P_{BOFF,X} is power which is 6 dB smaller than saturation power P_{s,X} of the two-input amplifier 4.

In a case where the power supply voltage is X(V), load modulation occurs in the two-input amplifier 4 when the output power P_{OUT} of the two-input amplifier 4 is in the range between the saturation power P_{s,X} of the two-input amplifier 4 and the backoff point power P_{BOFF,X} (P_{BOFF,X} ≤ P_{OUT} ≤ P_{s,X}). When load modulation occurs in the two-input amplifier 4, the two-input amplifier 4 operates highly efficiently.

The threshold Th₂ is a value equivalent to the amplitude E of the amplification-target signal at which, when the power supply voltage applied to the output side of each of the first amplifier 4a and the second amplifier 4b by the discrete variable power supply 5 is 0.5X(V), the output power P_{OUT} of the two-input amplifier 4 becomes backoff point power P_{BOFF,0.5X}. That is, the threshold Th₂ represents the lower limit value of an amplitude range of the amplification-target signal over which load modulation occurs in the two-input amplifier 4 when the power supply voltage is 0.5X(V). Note that the threshold Th₁ represents the upper limit value of the amplitude range of the amplification-target signal over which load modulation occurs in the two-input amplifier 4 when the power supply voltage is 0.5X(V). For example, the backoff point power P_{BOFF,0.5X} is power which is 6 dB smaller than saturation power P_{s,0.5X} of the two-input amplifier 4 at the time when the power supply voltage is 0.5X(V).

In a case where the power supply voltage is 0.5X(V), load modulation occurs in the two-input amplifier 4 when the output power P_{OUT} of the two-input amplifier 4 is in the range between the saturation power P_{s,0.5X} of the two-input amplifier 4 and the backoff point power P_{BOFF,0.5X} (P_{BOFF,0.5X} ≤ P_{OUT} ≤ P_{s,0.5X}). When load modulation occurs in the two-input amplifier 4, the two-input amplifier 4 operates highly efficiently.

In addition, in a case where the power supply voltage is 0.25X(V), load modulation occurs in the two-input amplifier 4 when the output power P_{OUT} of the two-input amplifier 4 is in the range between saturation power P_{s,0.25X} of the two-input amplifier 4 and backoff point power P_{BOFF,0.25X} (P_{BOFF,0.25X} ≤ P_{OUT} ≤ P_{s,0.25X}). For example, the backoff point power P_{BOFF,0.25X} is power which is 6 dB smaller than the saturation power Pₛ,_{0.25X} of the two-input amplifier 4 at the time when the power supply voltage is 0.25X(V). When load modulation occurs in the two-input amplifier 4, the two-input amplifier 4 operates highly efficiently.

The comparator 2 acquires the amplification-target signal from the input terminal 1.

The comparator 2 compares each of the thresholds Th₁ and Th₂ with the amplitude E of the amplification-target signal.

The comparator 2 outputs, to each of the signal splitter 3 and the discrete variable power supply 5, a result of the comparison of each of the thresholds Th₁ and Th₂ with the amplitude E.

As for the amplifying apparatus depicted in FIG. 1, when the amplitude E of the amplification-target signal is greater than the threshold Th₁, a first operation mode is decided as the operation mode of the two-input amplifier 4.

In a case where the amplitude E of the amplification-target signal is equal to or smaller than the threshold Th₁, and the amplitude E of the amplification-target signal is greater than the threshold Th₂, a second operation mode is decided as the operation mode of the two-input amplifier 4.

In a case where the amplitude E of the amplification-target signal is equal to or smaller than the threshold Th₂, a third operation mode is decided as the operation mode of the two-input amplifier 4.

The discrete variable power supply 5 acquires the comparison results of the comparator 2.

By referring to the comparison results of the comparator 2, the discrete variable power supply 5 recognizes the operation mode of the two-input amplifier 4.

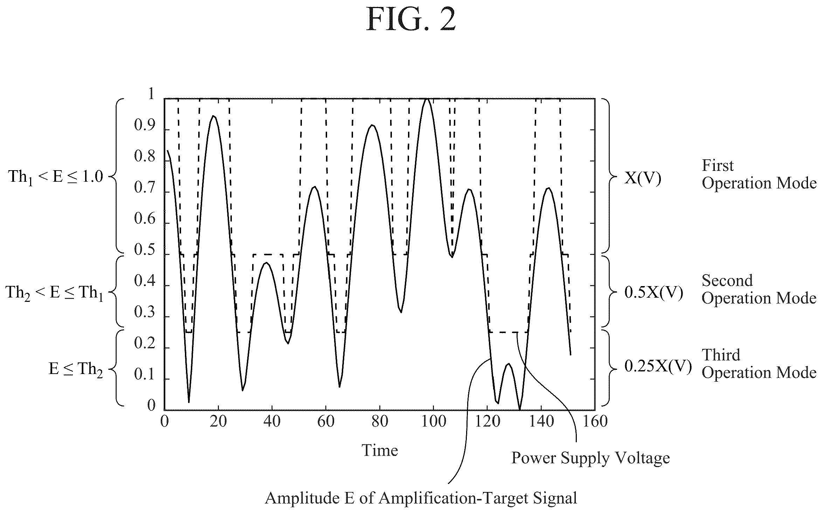

FIG. 2 is an explanatory diagram depicting the power supply voltage output from the discrete variable power supply 5.

In FIG. 2, the horizontal axis represents time, and the vertical axis represents each of the power supply voltage output from the discrete variable power supply 5 and the amplitude E of the amplification-target signal.

In a case where the operation mode of the two-input amplifier 4 is the first operation mode, as depicted in FIG. 2, the discrete variable power supply 5 applies the power supply voltage X(V) to the output side of each of the first amplifier 4a and the second amplifier 4b. X(V) is the maximum output power supply voltage of the discrete variable power supply 5.

In a case where the operation mode of the two-input amplifier 4 is the second operation mode, as depicted in FIG. 2, the discrete variable power supply 5 applies the power supply voltage 0.5X(V) to the output side of each of the first amplifier 4a and the second amplifier 4b. 0.5X(V) is half the maximum output power supply voltage of the discrete variable power supply 5.

In a case where the operation mode of the two-input amplifier 4 is the third operation mode, as depicted in FIG. 2, the discrete variable power supply 5 applies the power supply voltage 0.25X(V) to the output side of each of the first amplifier 4a and the second amplifier 4b. 0.25X(V) is one fourth of the maximum output power supply voltage of the discrete variable power supply 5.

The signal splitter 3 acquires the comparison results of the comparator 2.

By referring to the comparison results of the comparator 2, the signal splitter 3 recognizes the operation mode of the two-input amplifier 4.

In a case where the operation mode of the two-input amplifier 4 is the first operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage X(V) is applied. The total power of the power of the first input signal and the power of the second input signal is equal to the power of the amplification-target signal.

In the first operation mode, the output power P_{OUT} of the two-input amplifier 4 is power between the saturation power P_{s,X} of the two-input amplifier 4 and power which is, for example, 6 dB smaller than the saturation power P_{s,X}.

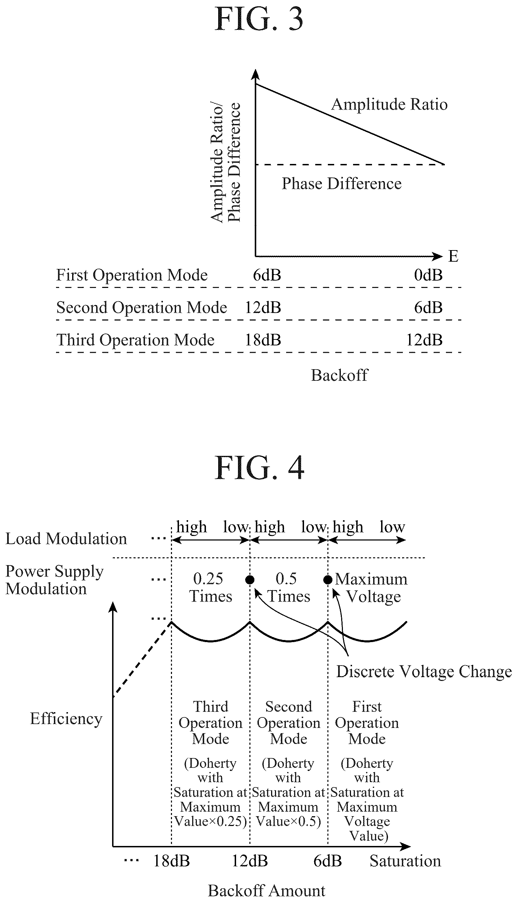

Specifically, as depicted in FIG. 3, the signal splitter 3 splits the amplification-target signal into the first input signal and the second input signal in such a manner that an amplitude ratio which is the ratio between the amplitude of the first input signal and the amplitude of the second input signal becomes an amplitude ratio corresponding to the amplitude E of the amplification-target signal.

FIG. 3 is an explanatory diagram depicting the amplitude ratio between the first input signal and the second input signal, and the phase difference between the first input signal and the second input signal.

In FIG. 3, the horizontal axis represents the amplitude E of the amplification-target signal, and the vertical axis represents each of the amplitude ratio and the phase difference.

In the example in FIG. 3, the amplification-target signal is split into the first input signal and the second input signal in such a manner that the amplitude ratio decreases as the amplitude E of the amplification-target signal increases.

In a case where the first amplifier 4a is a carrier amplifier, and the second amplifier 4b is a peak amplifier, the amplitude ratio is (the amplitude of the first input signal)/(the amplitude of the second input signal). In a case where the first amplifier 4a is a peak amplifier, and the second amplifier 4b is a carrier amplifier, the amplitude ratio is (the amplitude of the second input signal)/(the amplitude of the first input signal).

In addition, as depicted in FIG. 3, the signal splitter 3 splits the amplification-target signal into the first input signal and the second input signal in such a manner that a phase difference which is the difference between the phase of the first input signal and the phase of the second input signal becomes a phase difference corresponding to the amplitude E of the amplification-target signal.

In the example in FIG. 3, the amplification-target signal is split into the first input signal and the second input signal in such a manner that the phase difference remains unchanged even when the amplitude E of the amplification-target signal changes.

In a case where the operation mode of the two-input amplifier 4 is the second operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.5X(V) is applied. The total power of the power of the first input signal and the power of the second input signal is equal to the power of the amplification-target signal.

In the second operation mode, the output power P_{OUT} of the two-input amplifier 4 is power between power which is, for example, 12 dB smaller than the saturation power P_{s,X} of the two-input amplifier 4 and power which is, for example, 6 dB smaller than the saturation power P_{s,X}.

Specifically, as depicted in FIG. 3, the signal splitter 3 splits the amplification-target signal into the first input signal and the second input signal in such a manner that an amplitude ratio which is the ratio between the amplitude of the first input signal and the amplitude of the second input signal becomes an amplitude ratio corresponding to the amplitude E of the amplification-target signal.

In addition, as depicted in FIG. 3, the signal splitter 3 splits the amplification-target signal into the first input signal and the second input signal in such a manner that a phase difference which is the difference between the phase of the first input signal and the phase of the second input signal becomes a phase difference corresponding to the amplitude E of the amplification-target signal.

In a case where the operation mode of the two-input amplifier 4 is the third operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.25X(V) is applied. The total power of the power of the first input signal and the power of the second input signal is equal to the power of the amplification-target signal.

In the third operation mode, the output power P_{OUT} of the two-input amplifier 4 is power between power which is, for example, 18 dB smaller than the saturation power P_{s,X} of the two-input amplifier 4 and power which is, for example, 12 dB smaller than the saturation power P_{s,X}.

Specifically, as depicted in FIG. 3, the signal splitter 3 splits the amplification-target signal into the first input signal and the second input signal in such a manner that an amplitude ratio which is the ratio between the amplitude of the first input signal and the amplitude of the second input signal becomes an amplitude ratio corresponding to the amplitude E of the amplification-target signal.

In addition, as depicted in FIG. 3, the signal splitter 3 splits the amplification-target signal into the first input signal and the second input signal in such a manner that a phase difference which is the difference between the phase of the first input signal and the phase of the second input signal becomes a phase difference corresponding to the amplitude E of the amplification-target signal.

The signal splitter 3 outputs the first input signal to the first amplifier 4a in the two-input amplifier 4.

The signal splitter 3 outputs the second input signal to the second amplifier 4b in the two-input amplifier 4.

The first input signal is input from the signal splitter 3 to the first amplifier 4a.

The first amplifier 4a amplifies the first input signal, and outputs a signal obtained after the amplification to the synthesizing circuit 4c.

The second input signal is input from the signal splitter 3 to the second amplifier 4b.

The second amplifier 4b amplifies the second input signal, and outputs a signal obtained after the amplification to the synthesizing circuit 4c.

The power supply voltage applied to the output side of each of the first amplifier 4a and the second amplifier 4b has been switched on the basis of an amplitude range in which the amplitude E of the amplification-target signal is included, and the amplification-target signal has been split into the first input signal and the second input signal on the basis of the amplitude E of the amplification-target signal. Because of this, load modulation occurs in the two-input amplifier 4 independently of the amplitude E of the amplification-target signal.

The synthesizing circuit 4c synthesizes the signal obtained after the amplification by the first amplifier 4a and the signal obtained after the amplification by the second amplifier 4b.

The synthesizing circuit 4c outputs, to the output terminal 6, a composite signal of the signal obtained after the amplification by the first amplifier 4a and the signal obtained after the amplification by the second amplifier 4b.

Here, the relationship between the thresholds Th₁ and Th₂ and a power range in which load modulation occurs in the two-input amplifier 4 is explained specifically.

Assuming that a power range in which load modulation occurs in the two-input amplifier 4 is β dB, the thresholds Th₁ and Th₂ have a relationship in which their difference is equal to β dB. For example, in a case where β = 6 dB, the threshold Th₁ is the value of 6-dB backoff, and the threshold Th₂ is the value of 12-dB backoff.

If the thresholds Th₁ and Th₂ are expressed in voltage amplitude and antilogarithm, the thresholds Th₁ and Th₂ have an equal ratio relationship of 10^{(-β/20)}. Because of this, the threshold Th₁ is 0.5 times the maximum output power supply voltage X(V) of the discrete variable power supply 5, and the threshold Th₂ is 0.25 times the maximum output power supply voltage X(V) of the discrete variable power supply 5.

In addition, assuming that the power range in which load modulation occurs in the two-input amplifier 4 is β dB, the power supply voltage output from the discrete variable power supply 5 in each operation mode has an equal ratio relationship of 10^{(-β/20)}. Because of this, in the first operation mode, the power supply voltage output from the discrete variable power supply 5 is X(V), which is the maximum power supply voltage, and, in the second operation mode, the power supply voltage output from the discrete variable power supply 5 is X(V)×10^{(-β/20)}. In the third operation mode, the power supply voltage output from the discrete variable power supply 5 is X(V)×10^{(-β/20)×2}.

FIG. 4 is an explanatory diagram depicting the relationship between the backoff amount of the two-input amplifier 4 and the efficiency of the two-input amplifier 4.

In FIG. 4, the horizontal axis represents the backoff amount of the two-input amplifier 4, and the vertical axis represents the efficiency of the two-input amplifier 4.

In the range of the backoff amount from 6 dB to saturation, the power supply voltage output from the discrete variable power supply 5 is the maximum power supply voltage X(V). In the range of the backoff amount from 12 dB to 6 dB, the power supply voltage output from the discrete variable power supply 5 is 0.5 times the maximum power supply voltage X(V). In addition, in the range of the backoff amount from 18 dB to 12 dB, the power supply voltage output from the discrete variable power supply 5 is 0.25 times the maximum power supply voltage X(V).

In the example in FIG. 4, load modulation does not occur in the two-input amplifier 4 when the backoff amount is in the range smaller than 18 dB. Accordingly, the efficiency of the two-input amplifier 4 lowers further as the backoff amount increases.

In contrast, the power supply voltage output from the discrete variable power supply 5 is switched on the basis of an amplitude range in which the amplitude E of the amplification-target signal is included when the backoff amount is in the range from 18 dB to saturation. Accordingly, load modulation occurs in the two-input amplifier 4. Because of this, high efficiency is achieved as the efficiency of the two-input amplifier 4.

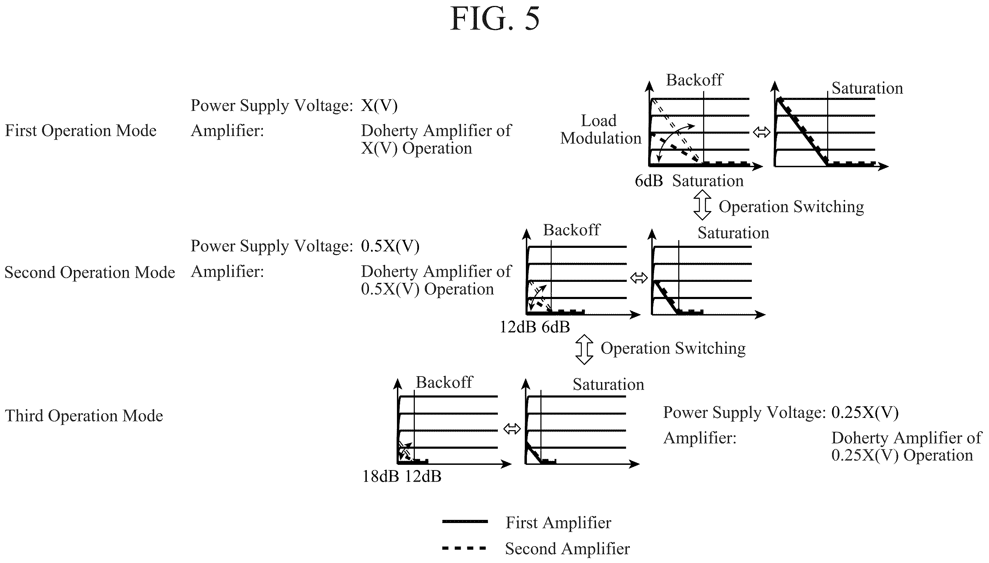

FIG. 5 is an explanatory diagram depicting each of backoff of the two-input amplifier 4 and saturation of the two-input amplifier 4 in each operation mode.

FIG. 5 depicts that, in the first operation mode, the power supply voltage is the maximum, which is X(V), and load modulation is performed in the range of the backoff amount from 6 dB to saturation. When the backoff amount is saturated, characteristics of the first amplifier 4a and the second amplifier 4b overlap.

FIG. 5 depicts that, in the second operation mode, the power supply voltage is 0.5X(V), and load modulation is performed in the range of the backoff amount from 12 dB to 6 dB. In the second operation mode, when the backoff amount is 6 dB, saturation occurs, and characteristics of the first amplifier 4a and the second amplifier 4b overlap.

FIG. 5 depicts that, in the third operation mode, the power supply voltage is 0.25X(V), and load modulation is performed in the range of the backoff amount from 18 dB to 12 dB. In the third operation mode, when the backoff amount is 12 dB, saturation occurs, and characteristics of the first amplifier 4a and the second amplifier 4b overlap.

In the first embodiment mentioned above, the amplifying apparatus includes: the signal splitter 3 that splits the amplification-target signal into the first input signal and the second input signal on the basis of the amplitude of the amplification-target signal; the first amplifier 4a that amplifies the first input signal; the second amplifier 4b that amplifies the second input signal; the synthesizing circuit 4c that synthesizes a signal obtained after the amplification by the first amplifier 4a and a signal obtained after the amplification by the second amplifier 4b; and the discrete variable power supply 5 that switches a power supply voltage applied to the output side of each of the first amplifier 4a and the second amplifier 4b on the basis of an amplitude range in which the amplitude of the amplification-target signal is included. Accordingly, the amplifying apparatus can expand the amplitude range of an amplification-target signal over which the output impedance of a synthesizing circuit changes as compared to the amplifying apparatus disclosed in Patent Literature 1.

### Second Embodiment.

In the amplifying apparatus explained in the first embodiment, thresholds to be compared with the amplitude E of the amplification-target signal are the thresholds Th₁ and Th₂.

The number of thresholds to be compared with the amplitude E of the amplification-target signal may be one or may be equal to or greater than three.

In an amplifying apparatus explained in a second embodiment, thresholds to be compared with the amplitude E of an amplification-target signal are three thresholds Th₁, Th₂, and Th₃.

The configuration of the amplifying apparatus according to the second embodiment is similar to the configuration of the amplifying apparatus according to the first embodiment, and the configuration diagram depicting the amplifying apparatus according to the second embodiment is FIG. 1.

As mentioned above, assuming that a power range in which load modulation occurs in a two-input amplifier 4 is β dB, the thresholds Th₁, Th₂, and Th₃ have a relationship in which their differences are equal to β dB. For example, in a case where β = 6 dB, the threshold Th₁ is the value of 6-dB backoff, the threshold Th₂ is the value of 12-dB backoff, and the threshold Th₃ is the value of 18-dB backoff.

If the thresholds Th₁, Th₂, and Th₃ are expressed in voltage amplitude and antilogarithm, the thresholds Th₁, Th₂, and Th₃ have an equal ratio relationship of 10^{(-β/20)}. Because of this, the threshold Th₁ is 0.5 times the maximum output power supply voltage X(V) of a discrete variable power supply 5, the threshold Th₂ is 0.25 times the maximum output power supply voltage X(V) of the discrete variable power supply 5, and the threshold Th₃ is 0.125 times the maximum output power supply voltage X(V) of the discrete variable power supply 5.

Note that, in a case where α (α is an integer which is equal to or greater than four) thresholds are used, a threshold Th_{α} is the value of (6×α)-dB backoff. The threshold Th_{α} is 10^{(-β/20)×(α-1)} times the maximum output power supply voltage X(V) of the discrete variable power supply 5.

In addition, assuming that the power range in which load modulation occurs in the two-input amplifier 4 is β dB, the power supply voltage output from the discrete variable power supply 5 in each operation mode has an equal ratio relationship of 10^{(-β/20)}. Because of this, in the first operation mode, the power supply voltage output from the discrete variable power supply 5 is X(V), which is the maximum power supply voltage, and, in the second operation mode, the power supply voltage output from the discrete variable power supply 5 is X(V)×10^{(-β/20)}. In the third operation mode, the power supply voltage output from the discrete variable power supply 5 is X(V)×10^{(-β/20)×2}. In the fourth operation mode, the power supply voltage output from the discrete variable power supply 5 is X(V)×10^{(-β/20)×3}.

Note that, in a case where the α thresholds are used, in the (α+1)-th operation mode, the power supply voltage output from the discrete variable power supply 5 is X(V)×10^{(-β/20)×α}.

In a case where the operation mode of the two-input amplifier 4 is the first operation mode, the discrete variable power supply 5 applies the power supply voltage X(V) to the output side of each of a first amplifier 4a and a second amplifier 4b.

In a case where the operation mode of the two-input amplifier 4 is the second operation mode, the discrete variable power supply 5 applies the power supply voltage 0.5X(V) to the output side of each of the first amplifier 4a and the second amplifier 4b.

In a case where the operation mode of the two-input amplifier 4 is the third operation mode, the discrete variable power supply 5 applies the power supply voltage 0.25X(V) to the output side of each of the first amplifier 4a and the second amplifier 4b.

In a case where the operation mode of the two-input amplifier 4 is the fourth operation mode, the discrete variable power supply 5 applies the power supply voltage 0.125X(V) to the output side of each of the first amplifier 4a and the second amplifier 4b.

In a case where the operation mode of the two-input amplifier 4 is the first operation mode, a signal splitter 3 splits the amplification-target signal into a first input signal and a second input signal on the basis of the amplitude E of the amplification-target signal in such a manner that load modulation in which the output impedance of a synthesizing circuit 4c changes along with a change of the amplitude E of the amplification-target signal occurs when the power supply voltage X(V) is applied.

In a case where the operation mode of the two-input amplifier 4 is the second operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.5X(V) is applied.

In a case where the operation mode of the two-input amplifier 4 is the third operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.25X(V) is applied.

In a case where the operation mode of the two-input amplifier 4 is the fourth operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.125X(V) is applied.

### Third Embodiment.

In an amplifying apparatus explained in a third embodiment, a signal splitter 8 changes each of the amplitude ratio corresponding to the amplitude E of an amplification-target signal, and the phase difference corresponding to the amplitude E of the amplification-target signal on the basis of the frequency of the amplification-target signal.

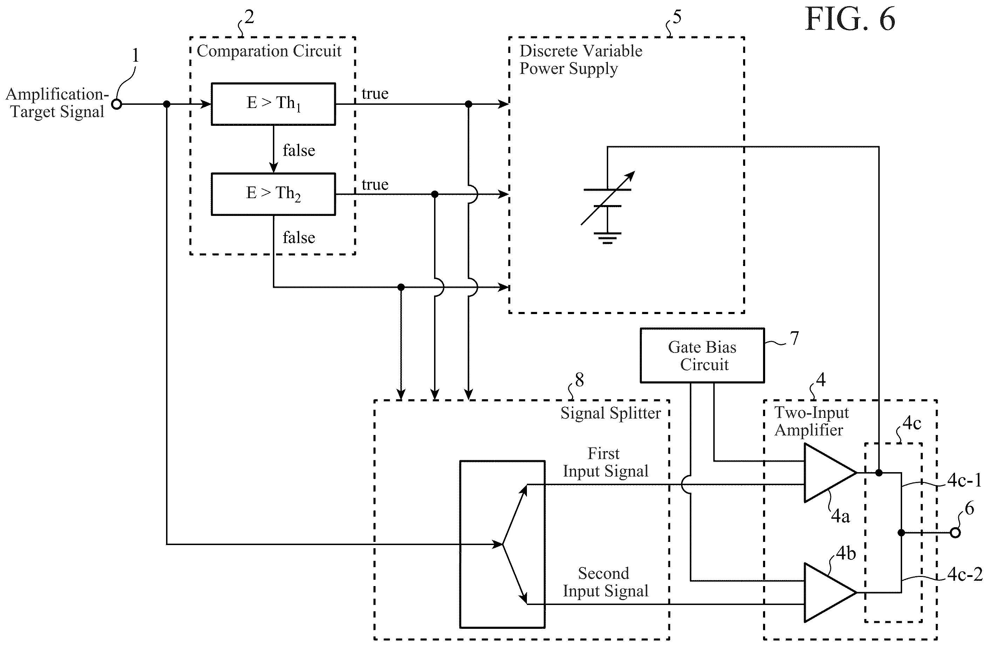

FIG. 6 is a configuration diagram depicting the amplifying apparatus according to the third embodiment. Reference signs in FIG. 6 that are identical to those in FIG. 1 represent identical or equivalent portions, and accordingly detailed explanation thereof is omitted.

The amplification-target signal is input from an input terminal 1 to the signal splitter 8.

In a case where the amplification-target signal is a digital signal, for example, the signal splitter 8 is implemented by a quadrature modulator.

In a case where the amplification-target signal is an analog signal, for example, the signal splitter 8 is implemented by an attenuator or a variable gain amplifier, and a phase shifter.

On the basis of the amplitude E of the amplification-target signal and comparison results output from the comparator 2, the signal splitter 8 splits the amplification-target signal into a first input signal and a second input signal.

When splitting the amplification-target signal into the first input signal and the second input signal, the signal splitter 8 changes each of the amplitude ratio corresponding to the amplitude of the amplification-target signal, and the phase difference corresponding to the amplitude of the amplification-target signal on the basis of the frequency of the amplification-target signal.

The signal splitter 8 outputs the first input signal to a first amplifier 4a in a two-input amplifier 4.

The signal splitter 8 outputs the second input signal to a second amplifier 4b in the two-input amplifier 4.

Next, operation performed by the amplifying apparatus depicted in FIG. 6 is explained.

As for the amplifying apparatus depicted in FIG. 6, in a case where the frequency of the amplification-target signal is f, for example, the first amplifier 4a operates as a carrier amplifier, and the second amplifier 4b operates as a peak amplifier.

As for the amplifying apparatus depicted in FIG. 6, in a case where the frequency of the amplification-target signal switches, for example, to f/2, for example, the first amplifier 4a operates as a peak amplifier, and the second amplifier 4b operates as a carrier amplifier.

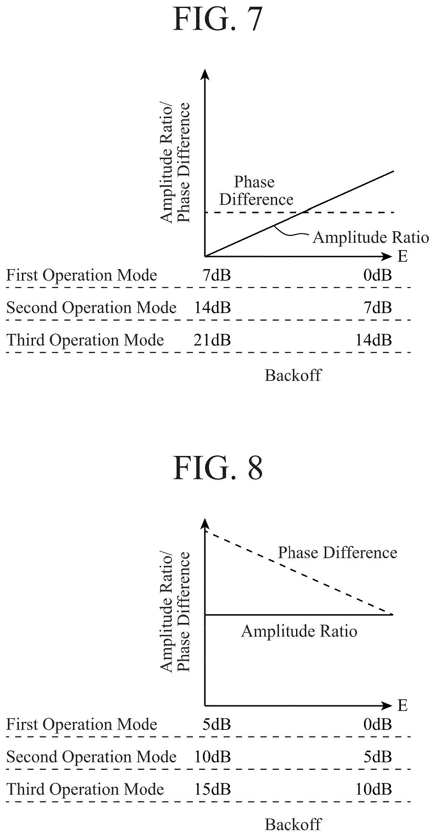

In a case where the frequency of the amplification-target signal switches from f to f/2, the backoff amount of the two-input amplifier 4 changes. In an example in FIG. 7 mentioned later, the backoff amount of the two-input amplifier 4 is 7 dB.

Assuming that a power range in which load modulation occurs in two-input amplifier 4 is β dB, the thresholds Th₁ and Th₂ have a relationship in which their difference is equal to β dB. For example, in a case where β = 7 dB, the threshold Th₁ is the value of 7-dB backoff, and the threshold Th₂ is the value of 14-dB backoff.

Accordingly, in a case where the backoff amount of the two-input amplifier 4 is 7 dB, the threshold Th₁ is set to the amplitude E of the amplification-target signal at the time when the output power P_{OUT} of the two-input amplifier 4 becomes power which is 7 dB smaller than saturation power P_{s,X} when the power supply voltage is X(V).

The threshold Th₂ is set to the amplitude E of the amplification-target signal at the time when the output power P_{OUT} of the two-input amplifier 4 becomes power which is 14 dB smaller than the saturation power P_{s,X}.

If the thresholds Th₁ and Th₂ are expressed in voltage amplitude and antilogarithm, the thresholds Th₁ and Th₂ have an equal ratio relationship of 10^{(-β/20)}. Because of this, the threshold Th₁ is 0.45 times the maximum output power supply voltage X(V) of a discrete variable power supply 5, and the threshold Th₂ is 0.20 (= 0.45×0.45) times the maximum output power supply voltage X(V) of the discrete variable power supply 5.

The comparator 2 acquires the amplification-target signal whose frequency is f/2 from the input terminal 1.

The comparator 2 compares each of the thresholds Th₁ and Th₂ with the amplitude E of the amplification-target signal.

The comparator 2 outputs, to each of the signal splitter 8 and the discrete variable power supply 5, a result of the comparison of each of the thresholds Th₁ and Th₂ with the amplitude E.

As for the amplifying apparatus depicted in FIG. 6, when the amplitude E of the amplification-target signal is greater than the threshold Th₁, a first operation mode is decided as the operation mode of the two-input amplifier 4.

In a case where the amplitude E of the amplification-target signal is equal to or smaller than the threshold Th₁, and the amplitude E of the amplification-target signal is greater than the threshold Th₂, a second operation mode is decided as the operation mode of the two-input amplifier 4.

In a case where the amplitude E of the amplification-target signal is equal to or smaller than the threshold Th₂, a third operation mode is decided as the operation mode of the two-input amplifier 4.

The discrete variable power supply 5 acquires the comparison results of the comparator 2.

By referring to the comparison results of the comparator 2, the discrete variable power supply 5 recognizes the operation mode of the two-input amplifier 4.

In a case where the operation mode of the two-input amplifier 4 is the first operation mode, the discrete variable power supply 5 applies the power supply voltage X(V) to the output side of each of the first amplifier 4a and the second amplifier 4b. X(V) is the maximum output power supply voltage of the discrete variable power supply 5.

In a case where the operation mode of the two-input amplifier 4 is the second operation mode, the discrete variable power supply 5 applies the power supply voltage 0.45X(V) to the output side of each of the first amplifier 4a and the second amplifier 4b.

In a case where the operation mode of the two-input amplifier 4 is the third operation mode, the discrete variable power supply 5 applies the power supply voltage 0.20X(V) to the output side of each of the first amplifier 4a and the second amplifier 4b.

The signal splitter 8 acquires the comparison results from the comparator 2.

By referring to the comparison results of the comparator 2, the signal splitter 8 recognizes the operation mode of the two-input amplifier 4.

In a case where the operation mode of the two-input amplifier 4 is the first operation mode, a signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage X(V) is applied. The total power of the power of the first input signal and the power of the second input signal is equal to the power of the amplification-target signal.

In the first operation mode, the output power P_{OUT} of the two-input amplifier 4 is power between the saturation power P_{s,X} of the two-input amplifier 4 and power which is 7 dB smaller than the saturation power P_{s,X}.

In a case where the operation mode of the two-input amplifier 4 is the second operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.45X(V) is applied. The total power of the power of the first input signal and the power of the second input signal is equal to the power of the amplification-target signal.

In the second operation mode, the output power P_{OUT} of the two-input amplifier 4 is power between power which is 14 dB smaller than the saturation power P_{s,X} of the two-input amplifier 4 and power which is 7 dB smaller than the saturation power P_{s,X}.

In a case where the operation mode of the two-input amplifier 4 is the third operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.20X(V) is applied. The total power of the power of the first input signal and the power of the second input signal is equal to the power of the amplification-target signal.

In the third operation mode, the output power P_{OUT} of the two-input amplifier 4 is power between power which is 21 dB smaller than the saturation power P_{s,X} of the two-input amplifier 4 and power which is 14 dB smaller than the saturation power P_{s,X}.

FIG. 7 is an explanatory diagram depicting the amplitude ratio between the first input signal and the second input signal, and the phase difference between the first input signal and the second input signal.

In FIG. 7, the horizontal axis represents the amplitude E of the amplification-target signal, and the vertical axis represents each of the amplitude ratio and the phase difference.

As depicted in FIG. 7, the signal splitter 8 splits the amplification-target signal into the first input signal and the second input signal in such a manner that the amplitude ratio increases as the amplitude E of the amplification-target signal increases. The amplitude ratio is (the amplitude of the second input signal)/(the amplitude of the first input signal).

In addition, as depicted in FIG. 7, the signal splitter 8 splits the amplification-target signal into the first input signal and the second input signal in such a manner that the phase difference remains unchanged even when the amplitude E of the amplification-target signal changes. It should be noted that the phase difference at this time is smaller than the phase difference at the time when the frequency of the amplification-target signal is f.

In a case where the frequency of the amplification-target signal switches from f to f/2, the backoff amount of the two-input amplifier 4 changes. In the example in FIG. 7, the backoff amount of the two-input amplifier 4 is 7 dB.

In the third embodiment above, the amplifying apparatus depicted in FIG. 6 includes the signal splitter 8 that changes each of the amplitude ratio corresponding to the amplitude of an amplification-target signal, and the phase difference corresponding to the amplitude of the amplification-target signal on the basis of the frequency of the amplification-target signal. Accordingly, in addition to being able to expand the amplitude range of an amplification-target signal over which the output impedance of a synthesizing circuit changes as compared to the amplifying apparatus disclosed in Patent Literature 1 similarly to the amplifying apparatus depicted in FIG. 1, the amplifying apparatus depicted in FIG. 6 can enhance the efficiency even when the frequency of the amplification-target signal changes.

As for the amplifying apparatus depicted in FIG. 6, the case where the frequency of the amplification-target signal has switched from f to f/2 is depicted. However, this is merely an example, and, for example, the frequency of the amplification-target signal switches from f to 2f/3 in some cases. In such a case also, the backoff amount of the two-input amplifier 4 changes. In the example in FIG. 8, the backoff amount of the two-input amplifier 4 is 5 dB, and the two-input amplifier 4 operates as an out-phasing amplifier.

Assuming that a power range in which load modulation occurs in the two-input amplifier 4 is β dB, the thresholds Th₁ and Th₂ have a relationship in which their difference is equal to β dB. For example, in a case where β =5 dB, the threshold Th₁ is the value of 5-dB backoff, and the threshold Th₂ is the value of 10-dB backoff.

Accordingly, in a case where the backoff amount of the two-input amplifier 4 is 5 dB, the threshold Th₁ is set to the amplitude E of the amplification-target signal at the time when the output power P_{OUT} of the two-input amplifier 4 becomes power which is 5 dB smaller than saturation power P_{s,X} when the power supply voltage is X(V).

The threshold Th₂ is set to the amplitude E of the amplification-target signal at the time when the output power P_{OUT} of the two-input amplifier 4 becomes power which is 10 dB smaller than the saturation power P_{s,X}.

If the thresholds Th₁ and Th₂ are expressed in voltage amplitude and antilogarithm, the thresholds Th₁ and Th₂ have an equal ratio relationship of 10^{(-β/20)}. Because of this, the threshold Th₁ is 0.56 times the maximum output power supply voltage X(V) of the discrete variable power supply 5, and the threshold Th₂ is 0.32 (= 0.56×0.56) times the maximum output power supply voltage X(V) of the discrete variable power supply 5.

The discrete variable power supply 5 acquires the comparison results from the comparator 2.

By referring to the comparison results of the comparator 2, the discrete variable power supply 5 recognizes the operation mode of the two-input amplifier 4.

In a case where the operation mode of the two-input amplifier 4 is the first operation mode, the discrete variable power supply 5 applies the power supply voltage X(V) to the output side of each of the first amplifier 4a and the second amplifier 4b.

In a case where the operation mode of the two-input amplifier 4 is the second operation mode, the discrete variable power supply 5 applies the power supply voltage 0.56X(V) to the output side of each of the first amplifier 4a and the second amplifier 4b.

In a case where the operation mode of the two-input amplifier 4 is the third operation mode, the discrete variable power supply 5 applies the power supply voltage 0.32X(V) to the output side of each of the first amplifier 4a and the second amplifier 4b.

The signal splitter 8 acquires the comparison results from the comparator 2.

By referring to the comparison results of the comparator 2, the signal splitter 8 recognizes the operation mode of the two-input amplifier 4.

In a case where the operation mode of the two-input amplifier 4 is the first operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage X(V) is applied. The total power of the power of the first input signal and the power of the second input signal is equal to the power of the amplification-target signal.

In the first operation mode, the output power P_{OUT} of the two-input amplifier 4 is power between the saturation power P_{s,X} of the two-input amplifier 4 and power which is 5 dB smaller than the saturation power P_{s,X}.

In a case where the operation mode of the two-input amplifier 4 is the second operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.56X(V) is applied. The total power of the power of the first input signal and the power of the second input signal is equal to the power of the amplification-target signal.

In the second operation mode, the output power P_{OUT} of the two-input amplifier 4 is power between power which is 10 dB smaller than the saturation power P_{s,X} of the two-input amplifier 4 and power which is 5 dB smaller than the saturation power P_{s,X}.

In a case where the operation mode of the two-input amplifier 4 is the third operation mode, the signal splitter 3 splits the amplification-target signal into the first input signal and the second input signal on the basis of the amplitude E of the amplification-target signal in such a manner that load modulation in which the output impedance of the synthesizing circuit 4c changes along with a change of the amplitude E of the amplification-target signal occurs when the power supply voltage 0.32X(V) is applied. The total power of the power of the first input signal and the power of the second input signal is equal to the power of the amplification-target signal.

In the third operation mode, the output power P_{OUT} of the two-input amplifier 4 is power between power which is 15 dB smaller than the saturation power P_{s,X} of the two-input amplifier 4 and power which is 10 dB smaller than the saturation power P_{s,X}.

FIG. 8 is an explanatory diagram depicting the amplitude ratio between the first input signal and the second input signal, and the phase difference between the first input signal and the second input signal.

In FIG. 8, the horizontal axis represents the amplitude E of the amplification-target signal, and the vertical axis represents each of the amplitude ratio and the phase difference.

As depicted in FIG. 8, the signal splitter 8 splits the amplification-target signal into the first input signal and the second input signal in such a manner that the amplitude ratio remains unchanged even when the amplitude E of the amplification-target signal changes.

In addition, as depicted in FIG. 8, the signal splitter 8 splits the amplification-target signal into the first input signal and the second input signal in such a manner that the phase difference decreases as the amplitude E of the amplification-target signal increases.

In a case where the frequency of the amplification-target signal switches from f to 2f/3, the backoff amount of the two-input amplifier 4 changes. In the example in FIG. 8, the backoff amount of the two-input amplifier 4 is 5 dB.

### Fourth Embodiment.

In the amplifying apparatus according to the first to third embodiments, each of the first amplifier 4a and the second amplifier 4b is biased for class B. That is, each of the gate terminal of the first amplifier 4a and the gate terminal of the second amplifier 4b is biased for class B by the gate bias circuit 7.

However, the examples in which each of the first amplifier 4a and the second amplifier 4b is biased for class B are not the sole examples. For example, the gate bias circuit 7 may switch the gate bias of each of the first amplifier 4a and the second amplifier 4b on the basis of the backoff amount of the two-input amplifier 4.

For example, the gate bias circuit 7 inputs, to each of the gate terminal of the first amplifier 4a and the gate terminal of the second amplifier 4b, gate bias that increases as the backoff amount of the two-input amplifier 4 increases.

Due to the gate bias control performed by the gate bias circuit 7, for example, the gain of each of the first amplifier 4a and the second amplifier 4b which changes depending on the amplitude E of the amplification-target signal can be smoothed. Due to the smoothing of the gain of each of the first amplifier 4a and the second amplifier 4b, it is possible to reduce distortion of the composite signal.

In addition, the gate bias circuit 7 may control the operating classes of the amplifiers by controlling gate bias on the basis of the load modulation mode of the two-input amplifier 4. For example, load modulation modes include a mode in which the two-input amplifier 4 operates as a Doherty amplifier, and a mode in which the two-input amplifier 4 operates as an out-phasing amplifier.

Specifically, the gate bias circuit 7 performs gate bias control in such a manner that gate bias control at the time when the two-input amplifier 4 operates as a Doherty amplifier, and gate bias control at the time when the two-input amplifier 4 operates as an out-phasing amplifier are different. For example, the gate bias circuit 7 performs gate bias control in such a manner that the gate bias at the time when the two-input amplifier 4 operates as an out-phasing amplifier is greater than the gate bias at the time when the two-input amplifier 4 operates as a Doherty amplifier.

It should be noted that this is merely an example. The gate bias circuit 7 may perform gate bias control in such a manner that the gate bias at the time when the two-input amplifier 4 operates as an out-phasing amplifier is smaller than the gate bias at the time when the two-input amplifier 4 operates as a Doherty amplifier. In addition, the gate bias circuit 7 may perform gate bias control in such a manner that gate bias control at the time when the two-input amplifier 4 operates as a Doherty amplifier, and gate bias control at the time when the two-input amplifier 4 operates as an out-phasing amplifier are the same.

Meanwhile, the gain of the two-input amplifier 4 can be increased in a case where the gate bias circuit 7 makes the gate bias of each of the first amplifier 4a and the second amplifier 4b equal to or greater than a threshold voltage when the two-input amplifier 4 performs backoff operation as a Doherty amplifier.

In addition, the gain of the two-input amplifier 4 can be increased in a case where the gate bias circuit 7 makes the gate bias of each of the first amplifier 4a and the second amplifier 4b equal to or greater than a threshold voltage when the two-input amplifier 4 performs backoff operation as an out-phasing amplifier.

Note that the present disclosure allows any combination of embodiments, modifications of any constituent elements in embodiments, and omission of any constituent elements in embodiments.

### INDUSTRIAL APPLICABILITY

The present disclosure is suited for an amplifying apparatus.

### REFERENCE SIGNS LIST

1: input terminal; 2: comparator; 3: signal splitter; 4: two-input amplifier; 4a: first amplifier; 4b: second amplifier; 4c: synthesizing circuit; 4c-1: first line; 4c-2: second line; 5: discrete variable power supply; 6: output terminal; 7: gate bias circuit; 8: signal splitter

## Claims

1. An amplifying apparatus comprising:
a signal splitter to split an amplification-target signal into a first input signal and a second input signal on a basis of amplitude of the amplification-target signal;
a first amplifier to perform amplification of the first input signal;
a second amplifier to perform amplification of the second input signal;
a synthesizing circuit to synthesize a signal obtained by the amplification performed by the first amplifier and a signal obtained by the amplification performed by the second amplifier; and
a discrete variable power supply to switch a power supply voltage applied to an output side of each of the first amplifier and the second amplifier on a basis of an amplitude range in which the amplitude of the amplification-target signal is included.

2. The amplifying apparatus according to claim 1, wherein
a plurality of amplitude ranges which are mutually different is provided for the amplitude range,
the amplifying apparatus further comprises a comparator to perform comparison of a thresholds representing lower limit values of the plurality of amplitude ranges, respectively, and the amplitude of the amplification-target signal, and output a result of the comparison of each of the thresholds with the amplitude, and
the discrete variable power supply switches the power supply voltage on a basis of the result of the comparison output from the comparator.

3. The amplifying apparatus according to claim 2, wherein the signal splitter splits the amplification-target signal into the first input signal and the second input signal on a basis of the amplitude of the amplification-target signal and the result of the comparison output from the comparator.

4. The amplifying apparatus according to claim 3, wherein the signal splitter splits the amplification-target signal into the first input signal and the second input signal in such a manner that an amplitude ratio which is a ratio between amplitude of the first input signal and amplitude of the second input signal corresponds the amplitude of the amplification-target signal, and a phase difference which is a difference between a phase of the first input signal and a phase of the second input signal corresponds the amplitude of the amplification-target signal.

5. The amplifying apparatus according to claim 4, wherein the signal splitter changes each of the amplitude ratio corresponding to the amplitude of the amplification-target signal, and the phase difference corresponding to the amplitude of the amplification-target signal on a basis of a frequency of the amplification-target signal.

6. The amplifying apparatus according to claim 1, further comprising a gate bias circuit to apply bias to each of the first amplifier and the second amplifier for class B.

7. The amplifying apparatus according to claim 1, further comprising a gate bias circuit to switch a gate bias of each of the first amplifier and the second amplifier on a basis of a backoff amount of a two-input amplifier including the first amplifier and the second amplifier.

8. The amplifying apparatus according to claim 1, further comprising a gate bias circuit to switch a gate bias of each of the first amplifier and the second amplifier on a basis of a mode of load modulation of a two-input amplifier including the first amplifier and the second amplifier.

9. The amplifying apparatus according to claim 1, wherein
the synthesizing circuit includes:
a first line having a first end connected to an output side of the first amplifier; and
a second line having a first end connected to an output side of the second amplifier, and having a second end connected to a second end of the first line,
the first line has an electrical length of 90 degrees at a center frequency of the amplification-target signal, and
the second line has an electrical length of 180 degrees at a center frequency of the amplification-target signal.

10. The amplifying apparatus according to claim 1, wherein
the discrete variable power supply includes an envelope amplifier, and
the envelope amplifier applies, to an output side of each of the first amplifier and the second amplifier, a power supply voltage that is switched on a basis of the amplitude range in which the amplitude of the amplification-target signal is included.
